# EUROPÄISCHE PATENTANMELDUNG

(11) **EP 0 629 453 A2**
(43) Veröffentlichungstag der Anmeldung: **21.12.1994**
(21) Anmeldenummer: 94107167.2
(22) Anmeldetag: 05.05.1994
(51) Int. Cl.: B05D 7/24, C23C 14/10

(54) **Schichtstoff und Verfahren zu seiner Herstellung**

(30) Priorität: 14.05.1993 DE 4316251
(71) Anmelder: Schmoock, Helmuth, D-21481 Buchhorst bei Lauenburg (DE)
(72) Erfinder: Schmoock, Helmuth, D-21481 Buchhorst bei Lauenburg (DE)
(74) Vertreter: Heldt, Gert, Dr. Dipl.-Ing.

(57) **Zusammenfassung**

Ein Schichtstoff besteht aus einer Trägerfolie, die auf mindestens einer ihrer Oberflächen mit einer einen Durchtritt von Gasen hemmenden Dichtschicht versehen ist. Zwischen der Dichtschicht und der ihr zugewandten Oberfläche der Trägerfolie ist eine die Oberflächenenergie beim Auftragen der Dichtschicht abbauende Zurichtung vorgesehen. Die Dichtschicht weist auf ihrer der Folie abgewandten Oberfläche eine Beschichtung auf, die mechanische Beschädigungen verhindert. Sie trägt auf ihrer der Folie abgewandten Oberfläche eine aus organischen Stoffen bestehende Beschichtung. Diese kann aus einem Gleitmittel oder aus Harzen bestehen, die auf der Dichtschicht festhaften. Die Harze können als Kunstharze ausgebildet sein. Die Beschichtung kann aber auch aus Wachsen bestehen, die fest auf der der Trägerfolie abgewandten Oberfläche der Dichtschicht haften. Sie können als Kunstwachse ausgebildet sein. Die Dichtschicht kann auf ihrer der Folie abgewandten Oberfläche eine aus organischen Stoffen bestehende Beschichtung tragen. Bei einem Verfahren zum Herstellen eines einen Durchtritt von Gasen hemmenden Schichtstoffs wird auf mindestens eine Oberfläche einer Trägerfolie eine Dichtschicht aufgetragen. Vor dem Auftragen der Dichtschicht wird auf die der Dichtschicht zugewandte Oberfläche der Trägerfolie eine Zurichtung aufgebracht, mit der die Oberflächenenergie beim Auftragen der Dichtschicht abgebaut wird. Bei einem anderen Verfahren zum Herstellen eines einen Durchtritt von Gasen hemmenden Schichtstoffs wird ebenfalls auf mindestens eine Oberfläche einer Trägerfolie eine Dichtschicht aufgetragen. Vor dem Auftragen der Dichtschicht auf die der Dichtschicht zugewandte Oberfläche der Trägerfolie wird eine Zurichtung aufgebracht, mit der Unebenheiten der Oberfläche geglättet und eine hochglänzende Oberfläche erzeugt wird. Bei einem dritten Verfahren zum Herstellen eines einen Durchtritt von Gasen hemmenden Schichtstoffs wird auf mindestens einer Oberfläche der Trägerfolie eine Dichtschicht aufgetragen. Vor dem Auftragen der Dichtschicht wird auf die der Dichtschicht zugewandte Oberfläche der Trägerfolie eine Zurichtung aufgebracht, mit der die Temperaturbeständigkeit der Oberfläche erhöht wird.

## Beschreibung

Die Erfindung betrifft einen Schichtstoff mit einer Trägerfolie, die auf mindestens einer ihrer Oberflächen mit einer eine Durchtritt von Gasen hemmenden Dichtschicht versehen ist.

Darüber hinaus betrifft die Erfindung ein Verfahren zum Herstellen eines einen Durchtritt von Gasen hemmenden Schichtstoffes, bei dem auf mindestens eine Oberfläche einer Trägerfolie eine Dichtschicht aufgetragen wird.

Derartige Schichtstoffe besitzen den Vorteil, daß sie in der Verpackungstechnik zum Herstellen von Umhüllungen geeignet sind, die einen relativ hohen Widerstand gegen Gasdurchtritt gewähren. Bei besonders hohen Ansprüchen an die Gasdichtigkeit müssen jedoch weitergehende Maßnahmen getroffen werden, die manchmal sehr kostenaufwendig sind. Beispielsweise sind Mehrschichtenverbundstoffe hergestellt worden, bei denen mindestens zwei Folien fest miteinander verbunden wurden. Diese Mehrschichtenverbundstoffe sind jedoch nicht nur sehr teuer, sondern darüber hinaus auch für den Verpackungszweck insofern nicht besonders gut geeignet, als sie vergleichsweise dick und wenig flexibel sind. Darüber hinaus wurden auch gasdichte Schichtstoffe unter Verwendung von PVDC hergestellt. Diese Schichtstoffe besitzen zwar eine relativ hohe Dichtigkeit gegen den Durchtritt von Sauerstoff und Wasserdampf. Bekanntlich ist aber PVDC nicht umweltfreundlich.

Aus diesen Gründen besitzen Schichtstoffe mit einer gasdichten Beschichtung, die beispielsweise aus Metall bestehen kann, eine relativ weitgehende Verbreitung. Grundsätzlich besitzen derartige Metallschichten, die beispielsweise auf die Trägerfolie aufgedampft werden, eine hohe Dichtigkeit gegen den Durchtritt von Gasen. Die Metallschicht ist gemeinsam mit der Trägerfolie geeignet, die Barriereeigenschaften des gesamten Schichtstoffes gegenüber denjenigen einer unbeschichteten Trägerfolie erheblich zu verbessern.

Dabei stellte sich jedoch heraus, daß der Schichtstoff verteilt über seine ganze Fläche sehr unterschiedliche Barriereeigenschaften aufweist. Zwar sind diese im Mittel wesentlich besser als die Barriereeigenschaften der unbehandelten Trägerfolie, aber trotzdem sind von Rolle zu Rolle und auch innerhalb einer bestimmten Rolle unregelmäßig verteilte Stellen im Schichtstoff anzutreffen, bei denen die Barriereeigenschaften schlechter als an anderen Stellen ausgebildet sind. Eine eingehende Untersuchung dieser mit schlechten Barriereeigenschaften ausgebildeten Stellen hat ergeben, daß an diesen eine besonders ungünstige Adsorption von kontaktierten Atomen bzw. Molekülen stattgefunden hat. Bei der Kondensation des Metalldampfes war an diesen Stellen eine besonders hohe Oberflächenenergie aufgetreten, die nicht abgebaut werden konnte und eine Verklammerung der aufgebrachten Metallschicht mit der Trägerfolie beeinträchtigte. Auf diese Weise wurde verhindert, daß sich die Oberflächenenergie des auftreffenden Metalldampfes nicht sättigen konnte. Dieser Mangel beruhte darauf, daß die Oberfläche der zu bedampfenden Trägerfolie einen unberechenbaren Untergrund für die Aufbringung der Metallschicht darbietet. Dieser Untergrund kann von Flächeneinheit zu Flächeneinheit sehr verschiedene Bedingungen für die Sättigung der Oberflächenenergie bieten. Einige Flächenelemente der Oberfläche besitzen eine besonders hohe Rauhigkeit, so daß sich die Unebenheiten dieser Oberfläche nach dem Aufdampfen der Metallbeschichtung auf deren der Trägerfolie abgewandten Seite deutlich erkennen lassen. Entsprechend diesen Rauhigkeitsunterschieden ist die Metallschicht unterschiedlich dicht ausgebildet, so daß an den dünnsten Stellen der Metallschicht Gasmoleküle durch die Metallschicht hindurchtreten können.

Darüber hinaus hat sich auch herausgestellt, daß auf der Oberfläche der Trägerfolie unterschiedliche Verhältnisse bezüglich der chemischen Sättigung des die Trägerfolie bildenden Materials vorherrschen. In einigen Bereichen der Oberfläche ist diese Sättigung weit vorangeschritten, während in anderen Bereichen die Verbindung noch weitgehend ungesättigt ist. Entsprechend diesem Sättigungsgrad findet eine gute oder schlechte Verhaftung der aufgedampften Metallschicht auf der Oberfläche der Trägerfolie statt. Der Abbau der Oberflächenspannung, die beim Aufdampfen des Metalls auf die Oberfläche entsteht, erfolgt entsprechend dem Sättigungsgrad des Materials in dem jeweiligen Oberflächenteil unterschiedlich gut.

Aufgabe der vorliegenden Erfindung ist es daher, einen Schichtstoff anzugeben, bei dem über die gesamte Oberfläche eine gleichmäßig gute Haftung der Dichtschicht auf der Trägerfolie stattfindet. Darüber hinausgehende Aufgabe der Erfindung ist es, ein Verfahren anzugeben, mit dessen Hilfe eine gute Bindung der Dichtschicht auf der Trägerfolie herbeigeführt werden kann.

Diese Aufgabe wird erfindungsgemäß dadurch gelöst, daß zwischen der Dichtschicht und der ihr zugewandten Oberfläche der Trägerfolie eine die Oberflächenenergie beim Auftragen der Dichtschicht abbauende Zurichtung vorgesehen ist.

Mit Hilfe dieser Zurichtung ist es möglich, die Oberfläche der Trägerfolie so weitgehend zu glätten, daß die Dichtschicht mit gleichmäßiger Schichtstärke auf die Trägerfolie aufgebracht werden kann. Insbesondere bei der Aufbringung der Dichtschicht in deren dampfförmiger Phase wird mit Hilfe der Zurichtung erreicht, daß die Oberflächenenergie durch die glatte Oberfläche des Trägermaterials abgesättigt wird. Die von dem Material der Dichtschicht kontaktierten Atome bzw. Moleküle der Zurichtung werden adsorbiert. Außerdem werden auf der gesamten Fläche der Trägerfolie gleichmäßig gute Verhältnisse für die Haftung der Dichtschicht erzeugt, so daß Adsorptionsunterschiede aufgrund unterschiedlicher Sättigung der die Trägerfolie bildenden chemischen Verbindung nicht zu befürchten sind. Schließlich wird mit Hilfe der Zurichtung eine weitgehende Temperaturbelastbarkeit der Folie erzeugt, da insbesondere bei einer hochglänzenden Oberfläche der Zurichtung eine unzulässig hohe Erhitzung der Dichtschicht, die deren Gasdurchlässigkeit zur Folge hätte, vermieden wird. Auf diese Weise entsteht eine dauerhafte und sehr gleichmäßige Haftung der aufgebrachten Dichtschicht auf der Trägerfolie.

Gemäß einer weiteren bevorzugten Ausführungsform der Erfindung besteht die glättende Beschichtung aus einem Material, das eine nahe chemische Verwandtschaft zu einem die Dichtschicht ausbildenden Material besitzt. Auf diese Weise wird erreicht, daß einander ähnliche Partner miteinander verhaftet werden. Dadurch kann der Energieabbau optimiert werden.

Gemäß einer weiteren bevorzugten Ausführungsform der Erfindung besteht die Beschichtung aus einem sehr dünn aufgetragenen Primer. Dieser ist in der Lage, die Oberfläche der Trägerfolie sehr glatt und eben zu gestalten. Der Primer füllt die mikrofeinen Unebenheiten in der Oberfläche der Trägerfolie aus und erzeugt eine hochglänzende Oberfläche, über die die Oberflächenspannung des kondensierenden Dampfes kompensiert werden kann. Auf diese Weise wird eine gute Haftung der Dichtschicht auf der die Trägerfolie bedekkenden Zurichtung erzeugt, so daß die Dichtschicht mit hoher Gleichmäßigkeit auf der gesamten Trägerfolie haftet.

Gemäß einer weiteren bevorzugten Ausführungsform der Erfindung besitzt der Primer eine Schichtdicke von 0,2 bis 0,6 g/m² Trockenanteil. Zweckmäßigerweise wird dieser Trockenanteil in einer organischen Lösung auf die Oberfläche der Trägerfolie aufgetragen.

Der Primer kann zweckmäßigerweise aus einem chlorierten Polypropylen bestehen. Dieses wird sehr dünn auf die Trägerfolie lackiert. Im unmittelbaren Anschluß an die Auftragung dieses lackförmigen chlorierten Polypropylens kann die Dichtschicht, beispielsweise eine Metallschicht, aus ihrer dampfförmigen Phase auf der getrockneten Lackschicht aus chloriertem Polypropylen niedergeschlagen werden. Dabei verringert sich der Energieinhalt der freien Oberfläche, so daß eine gute Haftung der Metallschicht auf der Lackschicht aus Polypropylen entsteht.

Darüber hinaus kann jedoch der Primer auch aus einem Harz bestehen. Dieser kann als ein Natur- oder als ein Kunstharz aufgetragen werden. Der Harz bildet eine hochglänzende Harzschicht von einer Stärke, die vorzugsweise zwischen 0,2 und 0,6 g/m² Trockenanteil liegt. Auch dieser Harz kann als Lack mit einem organischen Lösungsmittel aufgetragen werden.

Darüber hinaus kann die Zurichtung aus einem Silan bestehen. Auch dieses Silan kann in einem organischen Lösungsmittel gelöst sein. Zweckmäßigerweise wird bei der Auftragung einer aus Metall bestehenden Dichtschicht als Zurichtung ein Metallsilan verwendet.

Bevorzugt kann die Dichtschicht auf ihrer der Folie abgewandten Oberfläche eine mechanische Beschädigungen verhindernde Beschichtung aufweisen. Diese Beschichtung verhindert, daß beispielsweise beim Aufwickeln der mit der Dichtschicht versehenen Folie die Dichtschicht von einer Wickellage unmittelbar beaufschlagt wird, die ihr in einem Wickel benachbart ist. Diese Wickellage könnte bei einer unmittelbaren Beaufschlagung der Dichtschicht diese mechanisch zerstören, so daß auf diese Weise der Abdichteffekt der Dichtschicht in Frage gestellt würde. Durch die Aufbringung beispielsweise eines Gleitmittels kann erreicht werden, daß die benachbarte Wickellage auf der Dichtschicht gleitet, ohne diese zu verletzen. Es ist jedoch auch möglich, die Dichtschicht mit einer Beschichtung aus Harzen bzw. Wachsen zu versehen, die einen unmittelbaren Kontakt der Wickellage mit der Dichtschicht verhindern.

Zweckmäßigerweise werden als Dichtschicht entweder eine Metallschicht oder eine Schicht aus Siliciumoxid verwendet. In beiden Fällen besitzt die aufgedampfte Dichtschicht eine Gasundurchlässigkeit, die in der Lage ist, den gesamten Schichtstoff selbst gegen durchdringenden Sauerstoff abzudichten. Darüber hinaus ist der gesamte Schichtstoff dicht gegen den Durchtritt von Wasserdampf und CO₂. Sämtliche Aromastoffe, die beispielsweise den Inhalt einer Verpackung auszeichnen, werden am Austritt aus der Verpackung gehindert. Die Zurichtung sättigt die Oberfläche der Metallschicht ab. Sie erzeugt mikroporöse feine Blockeffekte. Durch die Beschichtung wird eine Beschädigung der Metallschicht beispielsweise aufgrund mechanischer Beanspruchung innerhalb einer Rolle verhindert. Darüber hinaus fördert diese Beschichtung die Bedruckbarkeit des Schichtstoffes.

Gemäß einer weiteren bevorzugten Ausführungsform der Erfindung kann als Trägerfolie eine Polyolefin-Folie zum Einsatz kommen. Dabei ist auch an eine Trägerfolie aus Polyethylen zu denken. Diese kann aufgrund ihrer Beschichtung mit einer Zurichtung, auf die die Dichtschicht und anschließend die eine mechanische Beschädigung der Dichtschicht verhindernde Beschichtung aufgebracht wird, als eine Monofolie eingesetzt werden, die nicht mit einer zweiten abdichtenden Folie kombiniert zu werden braucht. Auf diese Weise ist es denkbar, aus einem vergleichsweise preiswerten Folienmaterial eine hochgasdichte Folie herzustellen, die insbesondere für Verpackungszwecke hervorragend geeignet ist. Diese Folie ist darüber hinaus widerstandsfähig gegen mechanische Belastungen der Oberfläche, beispielsweise mechanische Kratzer. Sie ist darüber hinaus temperaturunempfindlich, da die Zurichtung schädigende Temperatureinflüsse von der Dichtschicht fernhält. Schließlich ist es auch noch möglich, auf die die Dichtschicht schützende Beschichtung einen Schutzlack aufzubringen, der einerseits die Beschichtung gegen Temperatureinflüsse schützt und andererseits die Schweißbarkeit des gesamten Schichtstoffes begünstigt. Einerseits ist der Schutzlack schweißbar und andererseits schützt er die Beschichtung, auf der er fest haftet, gegen hohe Temperaturen, die beim Schweißen auftreten.

Eine weitere Aufgabe der vorliegenden Erfindung besteht darin, ein Verfahren anzugeben, mit dessen Hilfe ein Schichtstoff erzeugt werden kann, der eine hohe Dichtigkeit gegen das Durchtreten von Gasen, insbesondere von Sauerstoff und Wasserdampf besitzt.

Diese Aufgabe wird erfindungsgemäß dadurch gelöst, daß vor dem Auftragen der Dichtschicht auf die der Dichtschicht zugewandten Oberfläche der Trägerfolie eine Zurichtung aufgebracht wird, mit der die Oberflächenenergie beim Auftragen der Dichtschicht abgebaut wird.

Über eine derartige Zurichtung kann die Oberflächenspannung minimiert werden, die insbesondere bei dampfförmiger Auftragung der Dichtschicht sich zwischen dieser und der Oberfläche der Trägerfolie aufbaut. Diese Oberflächenspannung verhindert, daß die aufgebrachte Dichtschicht sich über die gesamte Fläche der Trägerfolie gleichmäßig gut mit dieser verbindet. Durch eine Minimierung der Oberflächenspannung kann erreicht werden, daß eine gute Verhaftung der Dichtschicht auf der Trägerfolie stattfindet. Die Haftungserhöhung kann sich gegenüber einer Trägerfolie, auf deren Oberfläche keine Zurichtung aufgebracht ist, um etwa 10% erhöhen. Durch Herabsetzung der Oberflächenenergie durch Adsorption von kontaktierten Atomen oder Molekülen wird die Bereitschaft vergrößert, daß die Dichtschicht sich gleichmäßig gut an die Oberfläche der Trägerfolie bindet.

Gemäß einer bevorzugten Ausführungsform der Erfindung wird die Zurichtung auf die Trägerfolie aufgedruckt. Auf diese Weise ist es möglich, die Zurichtung in einer sehr gleichmäßig bleibenden Dicke auf die Trägerfolie aufzubringen. Dabei wird die Zurichtung zweckmäßigerweise aus einem Lösungsmittel auf die Oberfläche der Trägerfolie aufgetragen.

Bei Verwendung von Walzen mit einer hochglänzenden Oberfläche entsteht auch eine hochglänzende und fein verteilte Schicht auf der Trägerfolie, die in besonders guter Weise geeignet ist, für einen Ausgleich der Oberflächenenergie beim Auftragen der Dichtschicht zu sorgen. Außerdem erzeugt diese Schicht eine weitgehende Temperaturunempfindlichkeit der Dichtschicht bei etwa 140°C, so daß der gesamte Schichtstoff in die Lage versetzt wird, Schweißtemperaturen unbeschadet auszuhalten.

Schließlich kann die Zurichtung auch aus einem Material bestehen, das bevorzugt auf die Trägerfolie aufgedampft wird. Diese Aufdampfung erfolgt gemäß einer weiteren Ausführungsform der Erfindung zeitlich unmittelbar vor der Auftragung der Dichtschicht. Auf diese Weise können die beim Auftragen der jeweiligen Schicht auftretenden Oberflächenspannungen so aufeinander abgestimmt werden, daß alle drei Schichten sich gut miteinander verbinden.

Gemäß einer weiteren bevorzugten Ausführungsform der Erfindung wird eine die Dichtschicht gegen mechanische Beschädigungen schützende Beschichtung auf die der Zurichtung abgewandte Seite der Dichtschicht aufgedampft. Während die Zurichtung dafür sorgt, daß die Dichtschicht sich optimal mit der Trägerfolie verbindet, besteht die Aufgabe der Beschichtung darin, die Dichtschicht gegen mögliche mechanische Beschädigungen zu schützen. Auf diese Weise wird erreicht, daß die Dichtschicht die ihr eigene Dichtigkeit beibehält, ohne daß beispielsweise in der Dichtschicht durch mechanische Beanspruchungen Fehlstellen entstehen, die im Sinne der erwünschten Gasdichtigkeit erhebliche Leckstellen darstellen. Zweckmäßigerweise wird zur Herstellung der Beschichtung ein Schichtmaterial verwendet, das seinerseits eine sehr günstige Adsorption gegenüber den Molekülen der Dichtschicht aufweist.

Gemäß einer weiteren bevorzugten Ausführungsform der Erfindung besteht die Dichtschicht aus einem Metall, beispielsweise Aluminium. Der große Vorteil einer solchen Dichtschicht besteht darin, daß für die Aufdampfung des Aluminiums ein großer Erfahrungsschatz vorliegt, sodaß durch entsprechende Festlegung der Verdampfungsparameter eine gute Verhaftung der Aluminiummoleküle mit den Molekülen der Zurichtung stattfindet. Weltweit existiert ein großer Bestand an Bedampfungsanlagen, die umfangreich genutzt werden, so daß ein erheblicher Erfahrungsschatz auf dem Gebiet der Bedampfungstechnik weltweit vorhanden ist. Darüber hinaus liegen auch gute Erfahrungen über die Auswahl der Beschichtung vor, mit deren Hilfe die Aluminiumschicht gegen Beschädigungen geschützt werden kann.

Gemäß einer weiteren bevorzugten Ausführungsform der Erfindung kann auch bei Herstellung der Dichtschicht Siliciumoxid Verwendung finden. Auch dieses besitzt eine sehr hohe Dichte gegen durchtretende Gase. Durch entsprechende Auswahl der Zurichtung kann auch erreicht werden, daß das Siliciumoxid sich dauerhaft und gleichmäßig mit der Trägerfolie verbindet. Allerdings ist das Siliciumoxid ein vergleichsweise teurer Werkstoff, der in erster Linie Anwendung findet, wenn eine umweltfreundliche Beschichtung vorgenommen werden muß. Zweckmäßigerweise wird das Siliciumoxid auf die Zurichtung aufgedampft, die unter dem Gesichtspunkt ausgewählt wird, daß sie die beim Auftragen der Siliciumoxidschicht auftretenden Oberflächenenergien gut ableitet.

Gemäß einer weiteren bevorzugten Ausführungsform der Erfindung kann als Zurichtung ein Primer sehr dünn aufgetragen werden. Dieser besitzt zweckmäßigerweise einen Trockenbestandteil von 0,2 bis 0,6 g/m².

Gemäß einer weiteren bevorzugten Ausführungsform der Erfindung kann als Primer ein chloriertes Polypropylen auf die Trägerfolie aufgetragen werden. Jedoch ist es auch vorteilhaft, ein Harz oder ein Wachs als Primer auf die Trägerfolie aufzutragen.

Schließlich hat es sich als eine weitere günstige Ausführungsform herausgestellt, daß als Zurichtung ein Silan oder eine Mischung von Silanen mit anderen Stoffen, beispielsweise Harzen auf die Trägerfolie aufgetragen wird. Dabei wird zweckmäßigerweise ein dem Metall der Dichtschicht verwandtes Metallsilan ausgewählt.

Weitere Einzelheiten der Erfindung ergeben sich aus der nachfolgenden ausführlichen Beschreibung und den beigefügten Zeichnungen, in denen eine bevorzugte Ausführungsform der Erfindung beispielsweise veranschaulicht ist. In den Zeichnungen zeigen:

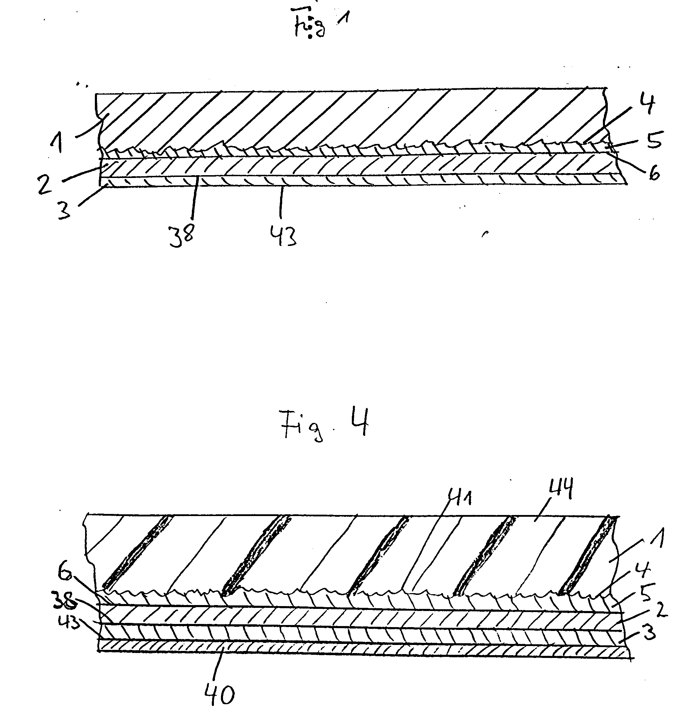

- Fig. 1:: Einen Querschnitt durch einen Schichtstoff,

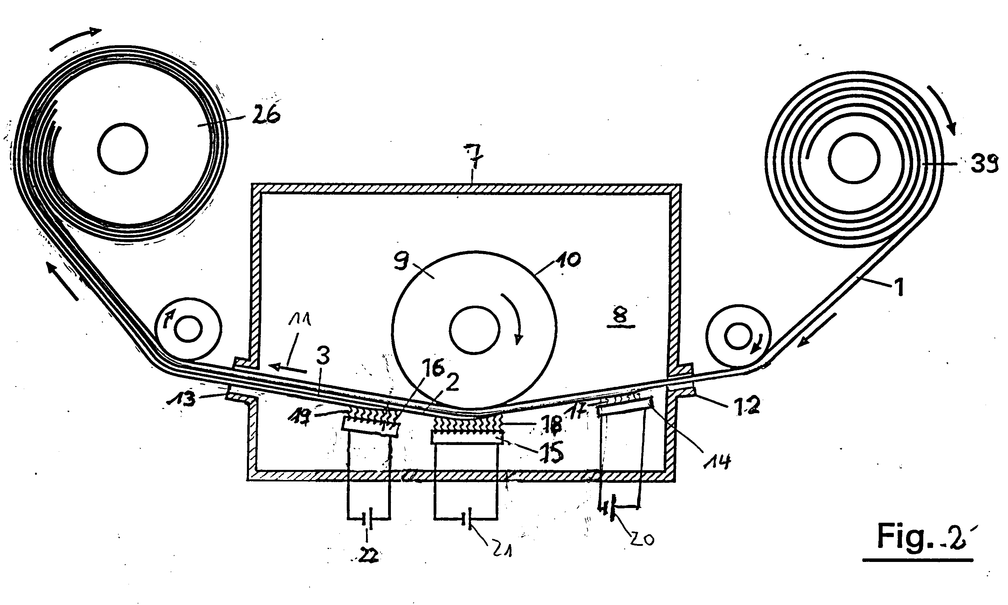

- Fig. 2:: eine schematische Darstellung einer Bedampfungsanlage mit einer Inline-Bedampfung der Zurichtung und der Beschichtung,

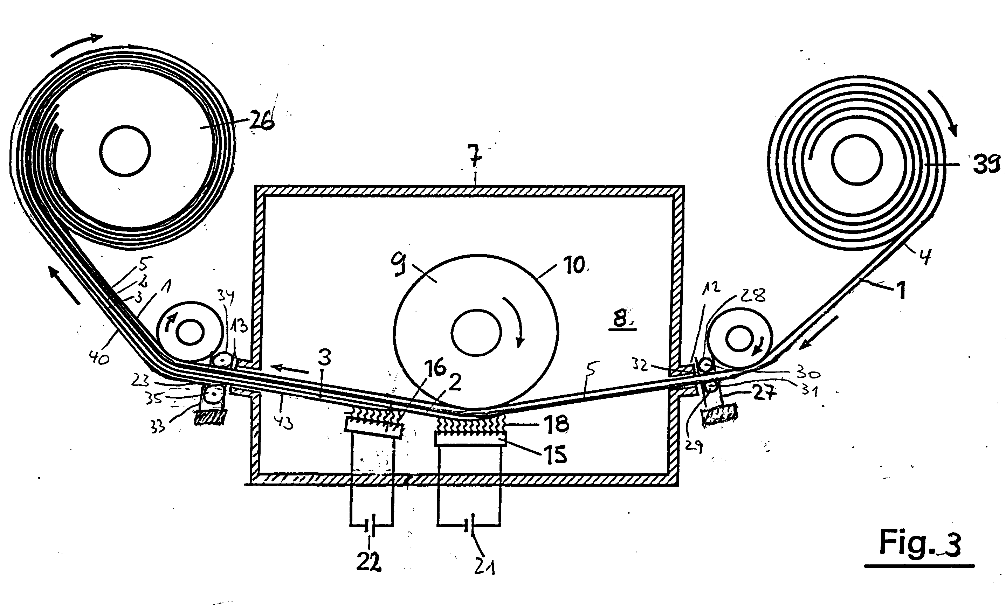

- Fig. 3:: eine schematische Darstellung einer anderen Bedampfungsanlage, bei der die Zurichtung außerhalb der Bedampfungsanlage aufgetragen wird und
- Fig. 4:: einen Querschnitt durch einen Schichtstoff auf der Basis einer Polyethylen-Folie.

Ein erfindungsgemäßer Schichtstoff besteht im wesentlichen aus einer Trägerfolie (1), einer Dichtschicht (2) sowie einer Schutzschicht (3). Auf diese Schutzschicht (3) kann zusätzlich ein Schutzlack (40) aufgetragen sein. Zwischen der Trägerfolie (1) und der Dichtschicht (2) ist auf eine der Dichtschicht (2) zugewandte Oberfläche (4) der Trägerfolie (1) eine Zurichtung (5) aufgetragen. Diese Zurichtung (5) haftet fest auf der Oberfläche (4) der Trägerfolie (1) und ist geeignet, diese einzuebnen. Auf diese Weise entsteht eine der Dichtschicht (2) zugewandte sehr ebene Oberfläche (6), die hochglänzend ausgebildet ist. Die Zurichtung (5) sorgt dafür, daß die Dichtschicht (2) auf die ebene Oberfläche (6) aufgetragen werden kann, so daß die Dichtschicht (2) auf der gesamten Fläche eine ebene Ausbildung aufweist. Würde die Dichtschicht (2) beispielsweise als eine Metallschicht unmittelbar auf die Oberfläche (4) der Trägerfolie (1) - wie üblich - aufgetragen, würden sich die Unebenheiten (41) der Oberfläche (4) quer durch die gesamte Dichtschicht (2) bis auf deren Oberfläche (38) bemerkbar machen. Durch die Einebnung der Unebenheiten (41) mit Hilfe der Zurichtung (5) erhält die Dichtschicht (2) über ihre gesamte Schichtstärke eine gleichmäßige Schichtdicke, die durch keinerlei Unebenheiten gestört ist.

Auf die hochglänzende Oberfläche (6) der Zurichtung (5) wird daher die Dichtschicht (2) aufgetragen. Diese kann bevorzugt aus einem Metall bestehen, das auf die Oberfläche (6) in einer Bedampfungsanlage (7) auf die ebene Oberfläche (6) der Zurichtung (5) aufgedampft wird. Bevorzugt wird zur Herstellung der Dichtschicht (2) Aluminium verwendet.

Durch die hochglänzende Oberfläche (6) der Zurichtung (5) wird eine hohe Temperaturbeständigkeit für den gesamten Schichtstoff und insbesondere für die Dichtschicht (2) erzielt. Einerseits ist die Auswahl für das Material der Zurichtung (5) so getroffen worden, daß die Zurichtung (5) temperaturbeständig ist und andererseits durch die hochglänzende Oberfläche (6) der Zurichtung (5) eine hohe Wärmeabstrahlung der über die Dichtschicht (2) eintretenden Wärme erfolgt.

Die Schutzschicht (3) wird auf eine der Zurichtung (5) abgewandte Oberfläche (38) der Dichtschicht (2) aufgebracht. Diese Schutzschicht (3) bewahrt die Oberfläche (38) der Dichtschicht (2) gegen mechanische Beschädigungen, beispielsweise in Form von Kratzern, die von außen auf die Dichtschicht (2) auftreffen würden, falls die Schutzschicht (3) nicht vorhanden wäre. Diese Kratzer können unter anderem dadurch entstehen, daß der Schichtstoff in einer Aufwickelrolle (26) aufgewickelt wird, in der deren einzelne Lagen (42) einander auf Druck beaufschlagen, so daß sie bei einer ungeschützten Dichtschicht (2) diese verletzen könnten. Insbesondere im Falle der Aufdampfung der Dichtschicht (2) beispielsweise aus Aluminium ist diese aufgedampfte Aluminiumschicht unmittelbar nach vollzogener Aufdampfung noch leicht verletzbar. Sie kann daher beim Aufwickeln in der Aufwickelrolle (26) durch Kratzer gasdurchlässig werden. Durch Aufbringung der Schutzschicht (3) ist dafür gesorgt, daß die Dichtschicht (2), die sehr dünn ist, mechanisch während der Veredelung der Trägerfolie (1) nicht mehr verletzt wird, so daß sie ihrer Abdichtfunktion gerecht werden kann. Darüber hinaus kann die Schutzschicht (3) auf ihrer der Dichtschicht (2) abgewandten Oberfläche (43) noch durch den Schutzlack (40) geschützt werden, der eine Abdeckfunktion besitzt und beispielsweise bei entsprechend hohen Temperaturen verschweißt werden kann. Im Falle des Verschweißens sorgt die Schutzschicht (3) dafür, daß die zum Schweißen verwendeten Schweißtemperaturen die Abdichtfunktion der Dichtschicht (2) nicht beeinträchtigen.

Die Zurichtung (5) dient dazu, die Haftung der Dichtschicht (2) auf der Oberfläche (4) der Trägerfolie so stark zu intensivieren, daß eine feste Verhaftung der Trägerfolie über die Zurichtung (5) mit der Dichtschicht (2) erfolgt. Zu diesem Zwecke wird die Zurichtung (5) aus einem Material hergestellt, das in der Lage ist, die Oberflächenenergie, die beim Auftragen der Dichtschicht auf die Trägerfolie entsteht, bis zur Sättigung abzubauen. Diese Oberflächenspannung ist insbesondere beim Aufdampfen von Metallen, aber auch beim Aufdampfen anderer anorganischer Stoffe, zum Beispiel Siliciumoxid (SiOx) groß und kann dazu führen, daß eine feste Verhaftung der Dichtschicht (2) mit der Trägerfolie (1) nicht zustande kommt. Diese dichte Verhaftung ist allerdings unverzichtbar, wenn mit Hilfe der Dichtschicht (2) ein Schichtstoff geschaffen werden soll, der dicht gegen den Durchtritt von Gasen, insbesondere von Sauerstoff und Wasserdampf ist bzw. den Durchtritt der Gase erheblich hemmt. Aus diesem Grunde hat die Zurichtung (5) vier Funktionen. Sie
- baut die beim Aufdampfen der Dichtschicht entstehende Oberflächenspannung ab,
- ebnet die Unebenheiten ein, die die Trägerfolie (1) auf ihrer Oberfläche (4) besitzt,
- vergleichmäßigt die Oberflächenbeschaffenheit auf der mit der Dichtschicht (2) zu bedampfenden Oberfläche (6) der Zurichtung (5) und
- erzeugt eine Temperaturunempfindlichkeit für den gesamten Schichtstoff, die insbesondere der Schweißbarkeit dieses Schichtstoffes entgegenkommmt.

Insbesondere die Vergleichmäßigung der Oberflächenbeschaffenheit spielt die angestrebte Dichtwirkung eine erhebliche Rolle. Diese Vergleichmäßigung der Oberflächenbeschaffenheit führt dazu, daß auch billige Massenfolien für eine Beschichtung zur Verfügung stehen, mit deren Hilfe sie gasdicht gemacht werden können. Gerade bei billigen Massenfolien zeigt die Oberfläche eine sehr unterschiedliche Beschaffenheit auf, je nachdem wie stark eine Sättigung des die Trägerfolie (1) bildenden Materials erfolgt ist. Im Falle einer Sättigung des Materials ist die Oberfläche (4) der Trägerfolie (1) für eine Bedampfung gut geeignet, während an anderen Stellen das Material ungesättigt ist und daher eine schlechte Haftung der bedampften Dichtschicht (2) auf der Oberfläche (4) aufweist. Die Zurichtung (5) schafft demgegenüber über die gesamte Oberfläche gleichmäßige Bedingungen für die Aufdampfung der Dichtschicht (2). Diese zeigt eine gute Verhaftung mit der Oberfläche (6) der Zurichtung (5).

Darüber hinaus adsorbieren die Moleküle und Atome der Zurichtung (5) die auf sie auftreffenden Moleküle und Atome der aufgedampften Dichtschicht (2). Der dadurch entstehende Energiegewinn ist umso größer, je ähnlicher die zusammengebrachten Materialien sind. In diesem Sinne wirkt die Zurichtung (5) als ein Haftungsvermittler zwischen der Oberfläche (4) der Trägerfolie und der Dichtschicht (2). Darüber hinaus wird der gesamte Schichtstoff durch die Zurichtung (5) kratz- und temperaturbeständig und erhält darüber hinaus eine hochglänzende Oberfläche. Durch richtige Auswahl dieser Zurichtung (5) kommt ein sehr enger Kontakt zwischen der Dichtschicht (2) und der Trägerfolie (1) zustande. Die Zurichtung (5) schließt die molekularen Unebenheiten der Oberfläche. Der dadurch erzeugte enge Kontakt zwischen der Trägerfolie (1) und der Dichtschicht (2) führt dazu, daß auch eine weitgehende Gasdichtigkeit im Bereich der Oberfläche (4) gewährleistet werden kann. Auf diese Weise wird die Auftragung einer gleichmäßig dicken Dichtschicht (2) auf die Zurichtung (5) möglich, so daß sich auf der der Trägerfolie (1) abgewandten Rückseite der Dichtschicht nicht mehr die Unebenheiten (41) abzeichnen können, in die bei fehlender Einebnung der Oberfläche (4) mit Hilfe der Zurichtung (5) die Dichtschicht (2) eindringen würde. Diese Unebenheiten führen zu der Gasundichtigkeit der Dichtschicht (2).

Im entsprechenden Sinne muß auch beim Auftragen der Schutzschicht (3) auf die Oberfläche (38) der Dichtschicht (2) darauf geachtet werden, daß die Dichtschicht (2) die aufgetragene Schutzschicht (3) gut adsorbiert. Dadurch wird verhindert, daß eine Wasser-Fettfilmunterwanderung die Wirksamkeit der Schutzschicht (2) aufhebt. Durch eine gute Adsorption der Schutzschicht (3) werden die beiden Schichten (2, 3) sehr eng miteinander verhaftet. Auf diese Weise kann die Schutzschicht (3) verhindern, daß die Dichtschicht (2) beispielsweise durch Kratzer mechanisch verletzt wird. Auf diese Weise bleibt die gesamte Schichtstoffkombination aufgrund der guten Verhaftung der einzelnen Schichten aufeinander gasdicht.

Wichtig für die angestrebte Adsorption ist nicht nur die Auswahl der miteinander zu verhaftenden Partner, sondern auch die Art und Weise, wie die Schichten aufeinander aufgetragen werden. Im Regelfall wird als Trägerfolie ein Polyolefin verwendet. Dabei kommen Folien aus Polypropylen und Polyethylen in Betracht. Die grobe Oberfläche (4) einer Polyethylenfolie (44) wird mit Hilfe der Zurichtung (5) soweit eingeebnet, daß sich auf der Oberfläche (38) der auf die Zurichtung (5) aufgebrachten Dichtschicht (2) die Unebenheiten (44) sich nicht mehr abzeichnen können. Auf diese Weise ist die Polyethylenfolie (44), die im Regelfall wegen ihrer groben Oberfläche nur als Schweißfolie Verwendung findet, zur Herstellung von gasdichten Schichtstoffen geeignet. Nach der Aufbringung der Zurichtung (5) kann eine hohe gasdichte Dichtschicht (2) auf die Zurichtung (5) aufgetragen werden. Die Oberfläche (38) dieser Dichtschicht (3) wird mit Hilfe einer Schutzschicht (3) gegen mechanische Verletzungen geschützt. Um die Schweißbarkeit dieser Polyethylenfolie (1) zu erhalten, wird die Schutzschicht (3) auf ihrer Oberfläche (43) mit einem Schutzlack (40) versehen, der schweißbar ist. Auf diese Weise ist es möglich, die Polyethylenfolie (1) als Monofolie für die Herstellung von gasdichten Folien zu verwenden. Aus dieser Polyehtylenfolie (44) können gasdichte Behälter, beispielsweise Beutel gefertigt werden, die angesichts des aufgebrachten Schutzlacks (40) eine hohe Siegelnahtdichtigkeit aufweist.

Darüber hinaus werden aber auch gute Ergebnisse mit anderen Trägerfolien beispielsweise aus Polyester erzielt. Trotz der vergleichsweise ebenen Oberfläche einer solchen Polyesterfolie wird auch diese mit Hilfe einer Zurichtung (5) vorbehandelt, bevor sie durch Aufbringung der Dichtschicht (2) gasdicht gemacht und durch Aufbringung der Schutzschicht (3) gegen mechanische Beschädigungen wirkungsvoll geschützt wird.

Je nach der Auswahl der verwendeten Folie ist die Zurichtung zu bestimmen, mit deren Hilfe eine gute Haftvermittlung zwischen der Trägerfolie (1) und der Dichtschicht (2) erfolgen kann. Zweckmäßigerweise wird für die Zurichtung (5) ein Material auf die Trägerfolie (1) aufgebracht, das eine unmittelbare Verwandtschaft zum Material der Trägerfolie (1) besitzt. Insofern kann zur Herstellung der Schutzschicht (3) ein sehr dünn aufgetragener Primer Verwendung finden, der eine nahe chemische Verwandtschaft einerseits zur Trägerfolie (1) und andererseits zur Dichtschicht (2) besitzt. Dieser Primer kann eine Schichtdicke von 0,2 bis 0,6 g/m² Trockenbestandteil aufweisen. Er kann bei Verwendung einer Trägerfolie (1) aus Polypropylen, beispielsweise aus einem chlorierten Polypropylen, bestehen. Dieses Polypropylen besitzt jedoch keine Haftung bei Verwendung einer Polyesterfolie. Daher können bei der Verwendung von Polyesterfolien nur Polyesterharze zur Herstellung des Primers Verwendung finden. Dabei werden zur Herstellung eines Primers Harze mit einer Stärke von 0,1 bis 0,2 g/m² Trockenbestandteil auf die Oberfläche (4) der Trägerfolie (1) aufgetragen. Zu diesem Zwecke kann das Harz in einem organischen Lösungsmittel gelöst sein und als Lack auf die Oberfläche (4) aufgetragen werden.

Andererseits kommen zur Ausbildung der Zurichtung (5) auch Silane in Betracht. Dabei ist die Verwendung eines Metallsilans besonders zweckmäßig, das chemisch dem Metall der Dichtschicht (2) verwandt ist. Auch dieses Silan kann in einem organischen Lösungsmittel gelöst sein, das eine chemische Verwandtschaft mit der Trägerfolie (1) besitzt.

Schließlich können zur Herstellung der Zurichtung (5) auch anorganische Substanzen Verwendung finden. Dabei ist insbesondere an eine Verbindung der SiOx-Gruppe zu denken. Mit Hilfe derartiger anorganischer Materialien zur Herstellung der Zurichtung (5) kann eine nahe chemische Verwandtschaft mit dem Metall der Dichtschicht (2) hergestellt werden.

Weiterhin ist es auch denkbar, für die Herstellung der Zurichtung (5) ein Gemisch aus organischen und anorganischen Bestandteilen zu benutzen. Dabei ist insbesondere daran zu denken, ein Metall, das dem Metall der Dichtschicht (2) möglichst nahe verwandt sein sollte, gemeinsam mit einem das Metall lösenden organischen Lösungsmittel auf die Trägerfolie (1) als Zurichtung (5) aufzutragen.

Entscheidend für jegliche Zurichtungen (5) ist die Tatsache, daß sie geeignet sein müssen, eine sehr ebene, möglichst hochglänzende Oberfläche (6) zu erzeugen. Diese ist in besonders günstiger Weise geeignet, die Oberflächenspannung beim Auftragen der Dichtschicht (2) so weitgehend abzubauen, daß sie einer intensiven Verhaftung zwischen der Dichtschicht (2) und der Zurichtung (5) förderlich ist. Darüber hinaus ist es zweckmäßig, bereits bei der Auswahl der Trägerfolie (1) eine Auswahl zu treffen. Insbesondere sollte eine Trägerfolie (1) mit hochglänzender Oberfläche zur Herstellung des Schichtstoffes ausgewählt werden.

Darüber hinaus kann zum Abbau der Oberflächenspannung noch durch die Auswahl der Auftragungsverfahren beigetragen werden. Dabei ist von besonderer Wichtigkeit, daß die aufzutragende Dichtschicht (2) unmittelbar nach ihrem Entstehen durch die Schutzschicht (3) abgedeckt wird, um zu verhindern, daß die soeben entstandene und daher noch sehr empfindliche Dichtschicht (2) durch mechanische Beschädigungen verletzt wird. Andererseits erweist sich auch als günstig, die Dichtschicht (2) unmittelbar nach dem Entstehen der Zurichtung (5) auf diese aufzutragen, da sich in der frisch aufgetragenen Zurichtung (5) starke Oberflächenspannungen, die eine intensive Verhaftung zwischen der Zurichtung (5) und der Dichtschicht (2) behindern könnten, noch nicht ausbilden können.

Zweckmäßigerweise wird daher die Auftragung der Zurichtung (5), der Dichtschicht (2) und der Schutzschicht (3) in unmittelbarer zeitlicher Reihenfolge vorgenommen. Diesem Zwecke dient die Bedampfungsanlage (7), in deren Innenraum (8) eine Führungsrolle (9) vorgesehen ist, über deren Oberfläche (10) die zu beschichtende Trägerfolie (1) geführt wird. Die zu beschichtende Oberfläche (4) der Trägerfolie (1) ist der Oberfläche (10) der Führungsrolle (39) abgewandt. Dieser Oberfläche (4) sind entlang eines Förderweges (11), auf dem die Trägerfolie (1) von einem Einlauf (12) der Bedampfungsanlage (7) zum Auslauf (13) gefördert wird, drei Quellen (14, 15, 16) zugeordnet, aus denen jeweils Dämpfe (17, 18, 19) in Richtung auf die zu bedampfende Oberfläche (4) aufsteigen. Die Quellen (14, 15, 16) besitzen Energieversorgungen (20, 21, 22), über die der Inhalt der Quellen (14, 15, 16) beheizt wird, so daß dieser unter dem Einfluß eines im Innenraum der Bedampfungsanlage (7) vorhandenen Vakuums verdampfen.

Die im Bereich des Einlaufes (12) von einer Vorratssrolle (9) abgewickelte Trägerfolie (1) gelangt in den Einflußbereich der aus der Quelle (14) aufsteigenden Dämpfe (17), die sich auf der Oberfläche (4) als Zurichtung (5) niederschlagen. Unmittelbar hinter der Quelle (14) gelangt die mit der Zurichtung (5) bedampfte Trägerfolie (1) auf ihrem Förderweg (11) in den Einflußbereich der aus der Quelle (15) aufsteigenden Metalldämpfe (18), die sich auf der Zurichtung (5) niederschlagen. Sie bilden auf der Trägerfolie (1) die Dichtschicht (2) aus.

Unmittelbar nach der Auftragung der Dichtschicht (2) gelangt die Trägerfolie (1) auf ihrem Förderweg (11) in den Einflußbereich der Quelle (16), aus der die Dämpfe (19) aufsteigen, die bei ihrer Kondensation auf der Dichtschicht (2) die Schutzschicht (3) ausbilden. Durch diese Schutzschicht (3) ist nunmehr die Dichtschicht (2) gegen mechanische Beschädigung geschützt, so daß sie nach dem Verlassen der Bedampfungsanlage (7) durch den Auslauf (13) auf eine entsprechend angeordnete Aufwickelrolle (26) aufgewickelt werden kann. Trotz der starken Kräfte, die zwischen den einzelnen Lagen der Aufwickelrolle (26) von einer Wickellage auf die nächste übertragen werden, ist die Dichtschicht (2) durch die Schutzschicht (3) gegen mechanische Beschädigungen gesichert.

Es ist jedoch auch möglich, die Zurichtung (5) auf die Trägerfolie (1) außerhalb der Bedampfungsanlage aufzubringen. Zu diesem Zwecke wird beispielsweise vor dem Einlauf (12) der Bedampfungsanlage (7) ein Kalander im Gerüst (27) installiert, in dem zwei Kalanderwalzen (28, 29) jeweils um Längsachsen (30, 31) drehbar gelagert sind. Zwischen den beiden Kalanderwalzen (28, 29) wird die Trägerfolie (1) durch einen Schlitz (32) geführt. Mit Hilfe der im Kalandergerüst (27) gelagerten unteren Kalanderwalze (29) wird auf die dieser zugewandten Oberfläche (4) der Trägerfolie (1) die Zurichtung (5) aufgedruckt. Auf diese Weise ist es möglich, die Zurichtung (5) in sehr kleinen Schichtstärken auf die Oberfläche (4) der Trägerfolie (1) aufzubringen.

Darüber hinaus kann aucn am Auslauf (13) der Bedampfungsanlage (7) ein Kalandergerüst (33) mit zwei Kalanderwalzen (34, 35) vorgesehen sein. Zwischen den beiden Kalanderwalzen (34, 35) öffnet sich ein Schlitz (23), durch den sich die Trägerfolie (1) mit der Zurichtung (5), der Dichtschicht (2) und der Schutzschicht (3) erstreckt. Mit Hilfe der im Kalandergerüst (33) unten gelagerten Kalanderwalze (35) wird auf die dieser Kalanderwalze (35) gewandte Oberfläche (43) der Schutzschicht (3) der Schutzlack (40) aufgedruckt. Dieser verleiht dem Schichtstoff die Möglichkeit, verschweißt zu werden, beispielsweise zu Behältern, wie Tüten und Beuteln. Der Schutzlack (40) kann farbig, transparent oder farbigtransparent sein.

## Patentansprüche

1. Schichtstoff mit einer Trägerfolie (1), die auf mindestens einer ihrer Oberflächen mit einer einen Durchtritt von Gasen hemmenden Dichtschicht (2) versehen ist, dadurch gekennzeichnet, daß zwischen der Dichtschicht (2) und der ihr zugewandten Oberfläche der Trägerfolie (1) eine die Oberflächenenergie beim Auftragen der Dichtschicht (2) abbauende Zurichtung (5) vorgesehen ist.

2. Schichtstoff nach Anspruch 1, dadurch gekennzeichnet, daß die Dichtschicht (2) auf ihrer der Folie (1) abgewandten Oberfläche (38) eine mechanische Beschädigungen verhindernde Beschichtung aufweist.

3. Schichtstoff nach Anspruch 1 und 2, dadurch gekennzeichnet, daß die Dichtschicht (2) auf ihrer der Folie (1), abgewandten Oberfläche (38) eine aus organischen Stoffen bestehende Beschichtung trägt.

4. Schichtstoff nach Anspruch 2 und 3, dadurch gekennzeichnet, daß die Beschichtung aus einem Gleitmittel besteht.

5. Schichtstoff nach Anspruch 2 und 3, dadurch gekennzeichnet, daß die Beschichtung aus auf der Dichtschicht (2) festhaftenden Harzen besteht.

6. Schichtstoff nach Anspruch 5, dadurch gekennzeichnet, daß die Harze als Kunstharze ausgebildet sind.

7. Schichtstoff nach Anspruch 2 und 3, dadurch gekennzeichnet, daß die Beschichtung aus Wachsen besteht, die fest auf der der Trägerfolie (1) abgewandten Oberfläche (38) der Dichtschicht (2) haften.

8. Schichtstoff nach Anspruch 7, dadurch gekennzeichnet, daß die Wachse als Kunstwachse ausgebildet sind.

9. Schichtstoff nach Anspruch 2, dadurch gekennzeichnet, daß die Dichtschicht (2) auf ihrer der Folie (1) abgewandten Oberfläche (38) eine aus anorganischen Stoffen bestehende Beschichtung trägt.

10. Schichtstoff nach Anspruch 9, dadurch gekennzeichnet, daß die anorganischen Stoffe aus einem Siliziumoxyd (SiOx) bestehen.

11. Schichtstoff nach Anspruch 1 bis 9, dadurch gekennzeichnet, daß die Beschichtung auf ihrer der Dichtschicht (2) abgewandten Oberfläche (43) mit einem Schutzlack (40) versehen ist.

12. Schichtstoff nach Anspruch 11, dadurch gekennzeichnet, daß der Schutzlack (40) ein Lösungsmittel aufweist.

13. Schichtstoff nach Anspruch 12, dadurch gekennzeichnet, daß das Lösungsmittel auf wässriger Basis beruht.

14. Schichtstoff nach Anspruch 11 bis 13, dadurch gekennzeichnet, daß der Schutzlack (40) farbig ist.

15. Schichtstoff nach Anspruch 11 bis 13, dadurch gekennzeichnet, daß der Schutzlack (40) transparent ist.

16. Schichtstoff nach Anspruch 11 bis 15, dadurch gekennzeichnet, daß der Schutzlack (40) farbig-transparent ist.

17. Schichtstoff nach Anspruch 11 bis 16, dadurch gekennzeichnet, daß der Schutzlack (40) schweißbar ist.

18. Schichtstoff nach Anspruch 1 bis 17, dadurch gekennzeichnet, daß die Zurichtung (5) aus einer die Oberfläche (4) der Trägerfolie (1) glättenden Beschichtung besteht.

19. Schichtstoff nach 1 bis 18, dadurch gekennzeichnet, daß die Zurichtung (5) eine der Trägerfolie (1) abgewandte hochglänzende Oberfläche (6) aufweist.

20. Schichtstoff nach Anspruch 18 und 19, dadurch gekennzeichnet, daß die glättende Beschichtung eine chemische Verwandtschaft zu einem die Dichtschicht (2) ausbildenden Material besitzt.

21. Schichtstoff nach Anspruch 18 bis 20, dadurch gekennzeichnet, daß die Beschichtung aus einem sehr dünn aufgetragenen Primer besteht.

22. Schichtstoff nach Anspruch 21, dadurch gekennzeichnet, daß der Primer eine Schichtdicke von 0,2 bis 0,6 g/m² Trockenanteil aufweist.

23. Schichtstoff nach Anspruch 21 und 22, dadurch gekennzeichnet, daß der Primer aus einem chlorierten Polypropylen besteht.

24. Schichtstoff nach Anspruch 21 und 22, dadurch gekennzeichnet, daß der Primer aus einem Harz besteht.

25. Schichtstoff nach Anspruch 24, dadurch gekennzeichnet, daß das Harz eine Stärke von 0,2 bis 0,6 g/m² Trockenanteil aufweist.

26. Schichtstoff nach Anspruch 24 und 25, dadurch gekennzeichnet, daß das Harz als Lack mit einem organischen Lösungsmittel versehen ist.

27. Schichtstoff nach Anspruch 21 bis 26, dadurch gekennzeichnet, daß der Lack auf die Trägerfolie (1) aufgedampft ist.

28. Schichtstoff nach Anspruch 1 bis 27, dadurch gekennzeichnet, daß die Zurichtung (5) ein Silan enthält.

29. Schichtstoff nach Anspruch 28, dadurch gekennzeichnet, daß die Zurichtung (5) ein Metallsilan enthält.

30. Schichtstoff nach Anspruch 29, dadurch gekennzeichnet, daß die Zurichtung (5) aus einer Mischung von mindestens zwei Silanen besteht.

31. Schichtstoff nach Anspruch 29 und 30, dadurch gekennzeichnet, daß das Metallsilan das Silan eines Metalles ist, das als Dichtschicht (2) auf die Zurichtung (5) aufgedampft ist.

32. Schichtstoff nach Anspruch 1 bis 31, dadurch gekennzeichnet, daß die Zurichtung (5) aus einer Mischung von organischen und anorganischen Substanzen besteht.

33. Schichtstoff nach Anspruch 1 bis 32, dadurch gekennzeichnet, daß die Zurichtung (5) eine hohe Kratzfestigkeit aufweist.

34. Schichtstoff nach Anspruch 1 bis 33, dadurch gekennzeichnet, daß die Zurichtung (5) eine molekulare Unebenheiten der Oberfläche (4) der Trägerfolie (1) schließende Konsistenz aufweist.

35. Schichtstoff nach Anspruch 1 bis 34, dadurch gekennzeichnet, daß die Zurichtung (5) als ein die Haftung zwischen der Oberfläche (4) der Trägerfolie (1) und der Dichtschicht (2) erhöhender Haftvermittler ausgebildet ist.

36. Schichtstoff nach Anspruch 1 bis 35, dadurch gekennzeichnet, daß die Zurichtung (5) als eine Beschichtung ausgebildet ist, die beim Aufdampfen der Dichtschicht (2) auf die Oberfläche (4) der Trägerfolie (1) auftretende Oberflächenspannungen absenkt.

37. Schichtstoff nach Anspruch 1 bis 36, dadurch gekennzeichnet, daß die Zurichtung (5) eine hohe Temperaturbeständigkeit aufweist.

38. Schichtstoff nach Anspruch 37, dadurch gekennzeichnet, daß die Zurichtung (5) bis mindestens 140° Celsius temperaturbeständig ist.

39. Schichtstoff nach Anspruch 37 und 38, dadurch gekennzeichnet, daß die Zurichtung (5) bei einer Erhitzung bis zu 140° ihre hochglänzende Oberfläche (6) beibehält.

40. Schichtstoff nach Anspruch 1 bis 39, dadurch gekennzeichnet, daß die Zurichtung (5) eine die Hafteigenschaften der Oberfläche (4) ausgleichende Konsistenz aufweist.

41. Schichtstoff nach Anspruch 1 bis 40, dadurch gekennzeichnet, daß die Trägerfolie (1) aus einem Polyolefin besteht.

42. Schichtstoff nach Anspruch 41, dadurch gekennzeichnet, daß die Trägerfolie (1) aus einem Polyethylen besteht.

43. Schichtstoff nach Anspruch 42, dadurch gekennzeichnet, daß die aus Polyethylen ausgebildete Trägerfolie (1) als Monofolie ausgebildet ist.

44. Schichtstoff nach Anspruch 43, dadurch gekennzeichnet, daß die Polyethylenfolie auf ihrer der Dichtschicht (2) zugewandten Oberfläche (4) mit einer Zurichtung (5) versehen ist, die in der Oberfläche (4) vorhandene Unebenheiten einebnet und eine hochglänzende Oberfläche (6) aufweist.

45. Schichtstoff nach Anspruch 43 und 44, dadurch gekennzeichnet, daß die auf die hochglänzende Oberfläche (6) aufgebrachte Dichtschicht (2) völlig eben ist und eine gleichbleibende Dicke aufweist.

46. Schichtstoff nach Anspruch 43 bis 45, dadurch gekennzeichnet, daß die Zurichtung (5) mikrofeine Mulden in der Oberfläche (4) der Polyethylenfolie ausfüllt.

47. Schichtstoff nach Anspruch 46, dadurch gekennzeichnet, daß die mit der Zurichtung (5) versehene Oberfläche (4) der Polyethylenfolie eine hohe Oberflächendichte aufweist.

48. Schichtstoff nach Anspruch 43 bis 47, dadurch gekennzeichnet, daß die mit der Zurichtung (5) versehene Oberfläche (4) der Polyethylenfolie molekular geschlossen ist.

49. Schichtstoff nach Anspruch 43 bis 48, dadurch gekennzeichnet, daß die mit der Zurichtung (5) versehene Oberfläche (4) der Polyethylenfolie eine hohe Kratzbeständigkeit aufweist.

50. Schichtstoff nach Anspruch 43 bis 49, dadurch gekennzeichnet, daß die Zurichtung (5) eine Oberfläche (6) aufweist, die eine beim Aufbringen der Dichtschicht (2) herabgesetzte Oberflächenspannung aufweist.

51. Schichtstoff nach Anspruch 43 bis 49, dadurch gekennzeichnet, daß die Oberfläche (6) der Zurichtung (5) eine gute Haftung gegenüber der auf sie aufgebrachten Dichtschicht (2) aufweist.

52. Schichtstoff nach Anspruch 43 bis 51, dadurch gekennzeichnet, daß die Zurichtung (5) eine hohe Temperaturbeständigkeit aufweist.

53. Schichtstoff nach Anspruch 52, dadurch gekennzeichnet, daß die Zurichtung (5) bis 140° Celsius temperaturbeständig ist.

54. Schichtstoff nach Anspruch 43 bis 53, dadurch gekennzeichnet, daß die auf die Zurichtung (5) aufgebrachte Dichtschicht (2) auf ihrer der Zurichtung (5) abgewandten Oberfläche (38) mit einer Schutzschicht (3) versehen ist, die aus einem organischen und/oder anorganischen Material besteht.

55. Schichtstoff nach Anspruch 54, dadurch gekennzeichnet, daß die Schutzschicht (3) auf ihrer der Dichtschicht (2) abgewandten Seite mit einem Schutzlack (40) versehen ist.

56. Schichtstoff nach Anspruch 55, dadurch gekennzeichnet, daß der Schutzlack (40) schweißbar ist.

57. Schichtstoff nach Anspruch 55 und 56, dadurch gekennzeichnet, daß der Schutzlack (40) farbig ist.

58. Schichtstoff nach Anspruch 55 bis 57, dadurch gekennzeichnet, daß der Schutzlack (40) transparent ist.

59. Schichtstoff nach Anspruch 55 bis 58, dadurch gekennzeichnet, daß der Schutzlack (40) farbig-transparent ist.

60. Schichtstoff nach Anspruch 1 bis 41, dadurch gekennzeichnet, daß die Trägerfolie (1) aus einem Polypropylen besteht.

61. Schichtstoff nach Anspruch 1 bis 40, dadurch gekennzeichnet, daß die Trägerfolie (1) aus einem Polyester besteht.

62. Schichtstoff nach Anspruch 1 bis 61, dadurch gekennzeichnet, daß die Dichtschicht (2) aus einem auf die Zurichtung (5) aufgedampften Metall besteht.

63. Schichtstoff nach Anspruch 62, dadurch gekennzeichnet, daß das Metall Aluminium ist.

64. Schichtstoff nach Anspruch 1 bis 61, dadurch gekennzeichnet, daß die Dichtschicht (2) aus einer aufgedampften Siliziumoxid-Schicht besteht.

65. Verfahren zum Herstellen eines einen Durchtritt von Gasen hemmenden Schichtstoffs gemäß den Ansprüchen 1 bis 64, bei dem auf mindestens einer Oberfläche einer Trägerfolie (2) eine Dichtschicht (2) aufgetragen wird, dadurch gekennzeichnet, daß vor dem Auftragen der Dichtschicht (2) auf die der Dichtschicht (2) zugewandte Oberfläche (4) der Trägerfolie (1) eine Zurichtung (5) aufgebracht wird, mit der die Oberflächenenergie beim Auftragen der Dichtschicht (5) abgebaut wird.

66. Verfahren zum Herstellen eines einen Durchtritt von Gasen hemmenden Schichtstoffs gemäß den Ansprüchen 1 bis 65, bei dem auf mindestens einer Oberfläche einer Trägerfolie (2) eine Dichtschicht (2) aufgetragen wird, dadurch gekennzeichnet, daß vor dem Auftragen der Dichtschicht (2) auf die der Dichtschicht (2) zugewandte Oberfläche (4) der Trägerfolie (1) eine Zurichtung (5) aufgebracht wird, mit der Unebenheiten der Oberfläche (4) geglättet und eine hochglänzende Oberfläche (4) erzeugt wird.

67. Verfahren zum Herstellen eines einen Durchtritt von Gasen hemmenden Schichtstoffes gemäß den Ansprüchen 1 bis 66, bei dem auf mindestens einer Oberfläche einer Trägerfolie (2) eine Dichtschicht (2) aufgetragen wird, dadurch gekennzeichnet, daß vor dem Auftragen der Dichtschicht (2) auf die der Dichtschicht (2) zugewandte Oberfläche (4) der Trägerfolie (1) eine Zurichtung (5) aufgebracht wird, mit der die Temperaturbeständigkeit der Oberfläche (4) erhöht wird.

68. Verfahren nach Anspruch 65 bis 67, dadurch gekennzeichnet, daß die Zurichtung (5) auf die Trägerfolie (1) aufgedruckt wird.

69. Verfahren nach Anspruch 65 bis 67, dadurch gekennzeichnet, daß die Zurichtung (5) auf die Trägerfolie (1) aufgedampft wird.

70. Verfahren nach Anspruch 68 und 69, dadurch gekennzeichnet, daß die Zurichtung (5) zeitlich unmittelbar vor der Auftragung der Dichtschicht (2) auf die Trägerfolie (1) aufgetragen wird.

71. Verfahren nach Anspruch 65 bis 70, dadurch gekennzeichnet, daß die Dichtschicht (2) auf die Zurichtung (5) aufgedampft wird.

72. Verfahren nach Anspruch 69 bis 71, dadurch gekennzeichnet, daß die Zurichtung (5) und die Dichtschicht (2) im gleichen Vakuum inline auf die Trägerfolie (1) aufgedampft werden.

73. Verfahren nach Anspruch 65 bis 72, dadurch gekennzeichnet, daß eine die Dichtschicht (2) gegen mechanische Beschädigungen schützende Beschichtung auf die der Zurichtung (5) abgewandte Oberfläche (38) der Dichtschicht (2) aufgedampft wird.

74. Verfahren nach Anspruch 69 bis 73, dadurch gekennzeichnet, daß zur Verhinderung mechanischer Beschädigungen der Dichtschicht (2) während der Veredelung der Trägerfolie (1) die Beschichtung im gleichen Vakuum wie die Dichtschicht (2) inline auf die Dichtschicht (2) aufgedampft wird.

75. Verfahren nach Anspruch 74, dadurch gekennzeichnet, daß die Aufdampfung der Zurichtung (5), der Dichtschicht (2) und der Beschichtung in unmittelbarer zeitlicher Reihenfolge hintereinander im gleichen Vakuum vorgenommen wird.

76. Verfahren nach Anspruch 75, dadurch gekennzeichnet, daß die Aufdampfung bei einem Vakuum vorgenommen wird, das zum Zwecke der Aufdampfung der Dichtschicht (2) erzeugt wird, und die Verdampfung der Zurichtung (5) und der Beschichtung bei einer Temperatur vorgenommen wird, die beim vorgegebenen Vakuum der jeweiligen Verdampfungstemperatur der Zurichtung (5) bzw. der Beschichtung entspricht.

77. Verfahren nach Anspruch 75 und 76, dadurch gekennzeichnet, daß als Dichtschicht (2) ein Metall aufgedampft wird.

78. Verfahren nach Anspruch 77, dadurch gekennzeichnet, daß als Metall Aluminium aufgedampft wird.

79. Verfahren nach Anspruch 65 bis 76, dadurch gekennzeichnet, daß als Dichtschicht (2) Siliziumoxyd aufgedampft wird.

80. Verfahren nach Anspruch 75 bis 79, dadurch gekennzeichnet, daß als Zurichtung (5) ein Primer sehr dünn aufgetragen wird.

81. Verfahren nach Anspruch 80, dadurch gekennzeichnet, daß der Primer mit einem Trockenbestandteil von 0,2 bis 0,6 g/m² aufgetragen wird.

82. Verfahren nach Anspruch 81, dadurch gekennzeichnet, daß als Primer ein chloriertes Polypropylen auf die Trägerfolie (1) aufgetragen wird.

83. Verfahren nach Anspruch 81, dadurch gekennzeichnet, daß als Primer ein Harz auf die Trägerfolie (1) aufgetragen wird.

84. Verfahren nach Anspruch 81, dadurch gekennzeichnet, daß als Primer ein Wachs auf die Trägerfolie (1) aufgetragen wird.

85. Verfahren nach Anspruch 81, dadurch gekennzeichnet, daß als Zurichtung (5) ein Silan auf die Trägerfolie (1) aufgetragen wird.

86. Verfahren nach Anspruch 81, dadurch gekennzeichnet, daß als Zurichtung (5) eine Gemisch aus einem Silan und einem Harz und/oder einem Wachs und/oder einem chlorierten Polypropylen auf die Trägerfolie (1) aufgetragen wird.

87. Verfahren nach Anspruch 85 und 86, dadurch gekennzeichnet, daß als Zurichtung (5) ein dem Metall der Dichtschicht (2) verwandtes Metallsilan auf die Trägerfolie (1) aufgetragen wird.

88. Verfahren nach Anspruch 80 bis 87, dadurch gekennzeichnet, daß auf einer der Trägerfolie (1) abgewandten Oberfläche der Zurichtung (5) eine sehr blanke Oberfläche erzeugt wird.

89. Verfahren nach Anspruch 88, dadurch gekennzeichnet, daß die Zurichtung (5) aus einem Gemisch organischer und anorganischer Bestandteile hergestellt wird.
